# EUROPEAN PATENT APPLICATION

(11) **EP 4 303 270 A1**
(43) Date of publication of application: **10.01.2024**
(21) Application number: 22763102.5
(22) Date of filing: 24.02.2022
(51) Int. Cl.: C08L 83/04, C09K 5/14, C08K 3/01

(54) **SOFT HEAT-CONDUCTING MEMBER**

(30) Priority: 02.03.2021 JP 2021032244
(71) Applicant: NOK Corporation, Tokyo 105-8585 (JP)
(72) Inventor: TSUNAJIMA, Shunichi, Fujisawa-shi, Kanagawa 2510042 (JP); UMEBAYASHI, Hiroshi, Fujisawa-shi, Kanagawa 2510042 (JP)
(74) Representative: Global IP Europe Patentanwaltskanzlei
(86) International application number: PCT/JP2022/007646
(87) International publication number: WO 2022/186046

(57) **Abstract**

There is provided a clay-like thermal conductive member having low adhesion and low hardness. A soft thermal conductive member comprising grease and thermal conductive particles, wherein the thermal conductive particles are contained in an amount of 550 to 800 parts by mass with respect to 100 parts by mass of the grease, the thermal conductive particles are composed of first thermal conductive particles having an average particle diameter of 30 to 55µm and second thermal conductive particles having an average particle diameter of 3 to 15µm, and a blending ratio of the first thermal conductive particles and the second thermal conductive particles is 7:3 to 5:5 on a mass basis, the type OO hardness is 70 or less, an adhesive strength at a temperature of 25°C in which a circular area with a diameter of 13mm is defined as a unit area is 10N or less, and a thermal conductivity is 0.4W/m K or more.

## Description

### Technical Field

The present invention relates to a soft thermal conductive member, and more particularly, to a low-adhesive clay-like thermal conductive member.

### Description of the Related Art

In recent years, the heat generation density of electronic components and substrates tends to increase due to miniaturization and higher performance of the electronic components. Therefore, heat dissipation of the electronic components and the substrates is a major problem.

Generally, the heat generated in electronic devices including electronic components and substrates is transmitted to a heatsink or the like to be cooled. In order to improve a contact condition of the heat-generating part and the heat-transfer component, and to transfer the heat efficiently, a grease, a gel sheet, and a rubber sheet having high thermal conductivity are often used as a heat dissipation component. In addition, these heat dissipation components often have an electric insulation so that they can be installed on electronic components or electronic substrates. For example, various types of greases such as silicone grease, a gel sheet made of silicone gel and the like have been conventionally proposed as a heat dissipation component (see, for example, Patent Documents 1 to 3).

### Citation List

### Patent Document

[Patent Document 1] JP-A-2005-42096
[Patent Document 2] JP-A-2019-169692
[Patent Document 3] JP-A-2009-241440

### SUMMARY OF THE INVENTION

### Problem to be Solved by the Invention

A grease and a gel sheet as a conventional heat dissipation component have various problems such as poor handling property when handling and inability to reuse them. The cause of such a problem is considered to be, for example, the low shape retention of the grease as a heat dissipation component and the high adhesion of the gel sheet.

On the other hand, a rubber sheet as a heat dissipation component has a problem in that adhesive property to a part of use is low and the efficiency of heat transfer is lowered. The reason for such a problem is considered to be that, for example, when a high load is applied to the electronic component, there is a risk of damage to the electronic component. For this reason, in order to adhere the rubber sheet to a part of use at a low load, the rubber constituting the rubber sheet may have a low hardness.

However, the lower the hardness of the rubber, the lower the shape retention of the rubber sheet and the higher the adhesion. Therefore, when the rubber sheet as a heat dissipation component is attempted to have low repulsion and high adhesive property, problems such as the above-described poor handling property of the grease and the gel sheet arise.

That is, as the heat dissipation component, the good shape retention and low adhesion for improving the handling property, and the low hardness for achieving good adhesive property are both demanding elements in the heat dissipation component, but they are antinomic (that is, in a trade-off relationship), and it has been extremely difficult to achieve both.

Patent Document 3 discloses a thermal conductive sheet including a thermal-conductive polymer layer formed of a thermal-conductive polymer composition containing a molecular matrix and a thermal conductive filler, and a resin layer formed by melting the thermoplastic resin powder after the powder adheres to at least one surface of a pair of surfaces of the thermal-conductive polymer layer. According to the technique described in Patent Document 3, both the handling property and the adhesive property can be achieved. However, in the technique described in Patent Document 3, since the heat dissipation component is limited to the sheet shape, when a part of use of the heat dissipation component includes a complicated shape such as an uneven shape, there is a limit in the shape followability of the heat dissipation component at the part of use, and there is a problem that the heat transfer efficiency is lowered.

In view of the above problems, according to the present invention, there is provided a low-adhesive clay-like soft thermal conductive member. That is, there is provided a soft thermal conductive member that achieves both the good shape retention and low adhesion for improving handling property and the low hardness for achieving good adhesive property.

### Means for Solving the Problems

In order to solve the above problems, the present invention provides the following soft thermal conductive member.
[1] A soft thermal conductive member comprising grease and thermal conductive particles, wherein
   the thermal conductive particles are contained in an amount of 550 to 800 parts by mass with respect to 100 parts by mass of the grease,
   the thermal conductive particles are composed of first thermal conductive particles having an average particle diameter of 30 to 55 µm and second thermal conductive particles having an average particle diameter of 3 to 15 µm, and a blending ratio of the first thermal conductive particles and the second thermal conductive particles is 7:3 to 5:5 on a mass basis,
   the type OO hardness is 70 or less,
   an adhesive strength at a temperature of 25°C in which a circular area with a diameter of 13mm is defined as a unit area is 10N or less, and
   a thermal conductivity is 0.4W/m·K or more.
[2] The soft thermal conductive member according to [1], wherein the average particle diameter of the first thermal conductive particles is 35 to 50µm, and the average particle diameter of the second thermal conductive particles is 4.5 to 9µm.
[3] The soft thermal conductive member according to [1] or [2], wherein the grease includes a silicone grease.
[4] The soft thermal conductive member according to any one of [1] to [3], wherein the thermal conductive particles are particles made of at least one material selected from the group consisting of metal oxides, metal nitrides, metal carbides, and metal hydroxides.
[5] The soft thermal conductive member according to [4], wherein the thermal conductive particles are any one of aluminum oxide particles, magnesium oxide particles, zinc oxide particles, boron nitride particles, aluminum nitride particles, silicon carbide particles, and aluminum hydroxide particles.
[6] The soft thermal conductive member according to any one of [1] to [5], wherein the consistency of the grease is 150 to 300.
[7] The soft thermal conductive member according to any one of [1] to [6], which is clay-like.
[8] The soft thermal conductive member according to any one of [1] to [7], wherein the type OO hardness is 0.5 to 60.
[9] The soft thermal conductive member according to any one of [1] to [8], wherein the thermal conductivity is 2 to 4W/m·K.
[10] The soft thermal conductive member according to any one of [1] to [9], wherein an adhesive strength at a temperature of 25°C of a circular area with a diameter of 13mm which is a unit area is 0.1 to 9N.

### Effect of the Invention

The soft thermal conductive member of the present invention has an effect of achieving both the good shape retention and low adhesion for improving handling property and the low hardness for achieving good adhesive property. Therefore, according to such a soft thermal conductive member, it is possible to enhance the handling property while having a low hardness. Accordingly, it is possible to have low repulsion and high adhesive property to a part of use. Further, it is possible to form the heat dissipation component into an arbitrary uneven shape corresponding to the part of use. It is possible to make contact with the uneven side surface of the part of use and to increase the contact area as compared with the conventional thermal conductive member having a sheet shape, and thus the thermal conductive performance is increased.

### BRIEF DESCRIPTION OF THE DRAWINGS

FIG. 1 is a schematic diagram showing an adhesive strength measuring system for performing the measurement of the adhesive strength.
FIG. 2 is a perspective view schematically showing a low-reaction-force thermal conductive member which is another embodiment of the soft thermal conductive member.
FIG. 3 is a cross-sectional view of the low-reaction-force thermal conductive member shown in FIG. 2.
FIG. 4 is a cross-sectional view showing a method of using the low-reaction-force thermal conductive member shown in FIG. 2.
FIG. 5 is a cross-sectional view showing a method of using the low-reaction-force thermal conductive member shown in FIG. 2.
FIG. 6 is a photograph showing the shape of the soft thermal conductive member.
FIG. 7 is a photograph showing the shape of the soft thermal conductive member.
FIG. 8 is a photograph showing the shape of the soft thermal conductive member.

### Mode for Carrying out the Invention

Hereinafter, embodiments of the present invention will be described. It should be understood that the present invention is not limited to the following embodiments, and changes, improvements, and the like of the design can be appropriately made based on ordinary knowledge of a person skilled in the art without departing from the spirit of the present invention.

The soft thermal conductive member of the present embodiment is a soft thermal conductive member including grease and thermal conductive particles. The soft thermal conductive member includes 550 to 800 parts by mass of the thermal conductive particles with respect to 100 parts by mass of the grease. The thermal conductive particles are composed of first thermal conductive particles having an average particle diameter of 30 to 55µm and second thermal conductive particles having an average particle diameter of 3 to 15µm, and a blending ratio of the first thermal conductive particles and the second thermal conductive particles is 7:3 to 5:5 on a mass basis.

Further, the soft thermal conductive member of the present embodiment has the type OO hardness of 70 or less, an adhesive strength at a temperature of 25°C of a circular area with a diameter of 13mm which is a unit area of 10N or less, and further, a thermal conductivity of 0.4W/m K or more.

The soft thermal conductive member of the present embodiment is grease containing thermal conductive particles (first thermal conductive particles and second thermal conductive particles) having different particle diameters as fillers with high thermal conductivity, and is a low-adhesive clay-like thermal conductive member.

The soft thermal conductive member of the present embodiment has an effect of achieving both the good shape retention and low adhesion for improving handling property and the low hardness for achieving good adhesive property. Therefore, according to the soft thermal conductive member of the present embodiment, it is possible to enhance the handling property while having a low hardness. Accordingly, it is possible to have low repulsion and high adhesive property to a part of use. Further, it is possible to form the heat dissipation component into an arbitrary uneven shape corresponding to the part of use. It is possible to make contact with the uneven side surface of the part of use and to increase the contact area as compared with the conventional thermal conductive member having a sheet shape, and thus the thermal conductive performance is increased.

The grease is not particularly limited as long as it is a semi-solid or a solid obtained by dispersing a thickener in a raw material base oil. That is, the type of the raw material base oil and the thickener is not particularly limited, and a material appropriately prepared so that the type OO hardness and the adhesive strength satisfy the above-described numerical values can be used. For example, the raw material base oil may include mineral oils, synthetic oils, other animal and vegetable oils, and mixed oils thereof. The type of the thickener is also not particularly limited, and conventionally known thickeners such as a metal-soap thickener such as lithium soap or calcium soap, and a non-soap thickener such as silica, urea, PTFE, or benton are used.

In the soft thermal conductive member of the present embodiment, it is preferable that the grease contained is the grease whose raw material base oil is silicone oil, and it is more preferable that the grease is silicone grease. Examples of the silicone grease include "HVG grease (trade name)" manufactured by Toray Dow Corning Co., Ltd.

The immiscible consistency of the grease is preferably 100 to 400, more preferably 150 to 300. The consistency of the grease can be measured according to JIS K 2200-2013 using a consistency tester. As the consistency tester, for example, a needle penetration tester "RPM-201" manufactured by RIGO Co., Ltd. can be used.

In addition to the grease described above, the soft thermal conductive member includes thermal conductive particles as thermal conductive fillers. By including an appropriate amount of such thermal conductive particles, it is possible to enhance shape retention while having low hardness. Further, the thermal conductivity of the soft thermal conductive member can also be set to an appropriate value. Although not particularly limited, the amount of the thermal conductive particles is preferably 550 to 800 parts by mass, and more preferably 600 to 700 parts by mass with respect to 100 parts by mass of the grease. If the blending amount of the thermal conductive particles is too small, the thermal conductivity and the shape retention may be lowered, and for example, the effect of suppressing the adhesion of the soft thermal conductive member may hardly be exhibited. On the other hand, the higher the blending amount of the thermal conductive particles, the higher the thermal conductivity and shape retention of the soft thermal conductive member, but if the blending amount of the thermal conductive particles is too large, the hardness of the soft thermal conductive member (e.g., the type OO hardness) is increased, the integrity of the grease and the thermal conductive particles is degraded, the shape retention of the soft thermal conductive member may become difficult.

The thermal conductive particles comprise first thermal conductive particles having an average particle diameter of 30 to 55µm and second thermal conductive particles having an average particle diameter of 3 to 15µm. That is, the soft thermal conductive member includes two kinds of thermal conductive particle powders having different particle diameters as the thermal conductive particles as thermal conductive fillers. With such a configuration, the filling property of the thermal conductive particles in the soft thermal conductive member is increased, and the effect of enhancing the shape retention while having a low hardness becomes more remarkable. In particular, by including two kinds of thermal conductive particle powders having different particle diameters as described above and having a spherical shape, the closest filling of the thermal conductive particles is realized. Here, the particle diameter of the thermal conductive particles is a value measured by a laser diffraction particle size distribution analysis (apparatus: Microtrac).

The blending ratio of the first thermal conductive particles to the second thermal conductive particles is 7:3 to 5:5 on a mass basis. When the blending ratio falls outside the range, the filling property of the thermal conductive particles is lowered, the hardness of the soft thermal conductive member is increased, the integrity of the grease and the thermal conductive particles is lowered, and it becomes difficult to maintain the shape of the soft thermal conductive member.

The thermal conductive particles may be electroconductive particles (e.g., electroconductive fillers) or insulative particles (e.g., insulative fillers). Examples of the material of the electroconductive particles include metal and carbon, and may be particles made of a single material or a combination of two or more materials. Specific examples of the electroconductive particles include aluminum particles, copper particles, silver particles, carbon particles, carbon fibers, diamond, and graphite. In a case where the thermal conductive particles (thermal conductive fillers) having electroconductivity are included in the soft thermal conductive member, the soft thermal conductive member may exhibit electroconductivity derived from the thermal conductive fillers. When using such a soft thermal conductive member in a place where insulation is required, for example, by applying an insulation treatment by coating the thermal conductive member, or by providing an insulating member to the thermal conductive member, it is possible to ensure insulation with the soft thermal conductive member.

The thermal conductive particles are preferably insulating particles (for example, insulating fillers). For example, the thermal conductive particles are preferably particles made of at least one material selected from the group consisting of metal oxides, metal nitrides, metal carbides, and metal hydroxides. Furthermore, it is particularly preferable that the thermal conductive particles are any of aluminum oxide particles, magnesium oxide particles, zinc oxide particles, boron nitride particles, aluminum nitride particles, silicon carbide particles, or aluminum hydroxide particles. The first thermal conductive particles and the second thermal conductive particles may be particles made of the same material or may be particles made of different materials. However, the first thermal conductive particles and the second thermal conductive particles are preferably particles made of the same material.

The average particle diameter of the first thermal conductive particles is preferably 30 to 55µm, more preferably 35 to 50µm, and particularly preferably 45µm. The average particle diameter of the second thermal conductive particles is preferably 3 to 15µm, more preferably 4.5 to 9µm, and particularly preferably 5µm. The average particle diameters of the first thermal conductive particles and the second thermal conductive particles are cumulative average values based on a volume measured by a laser diffraction particle size distribution analysis (apparatus: Microtrac).

The type OO hardness of the soft thermal conductive member is 70 or less, preferably 0.5 to 60, and particularly preferably 0.5 to 50. The type OO hardness can be measured according to ASTM-D 2240-2015 using a hardness tester. As the hardness tester, for example, a durometer "GSD-754K (trade name)" manufactured by Teclock Co., Ltd. can be used.

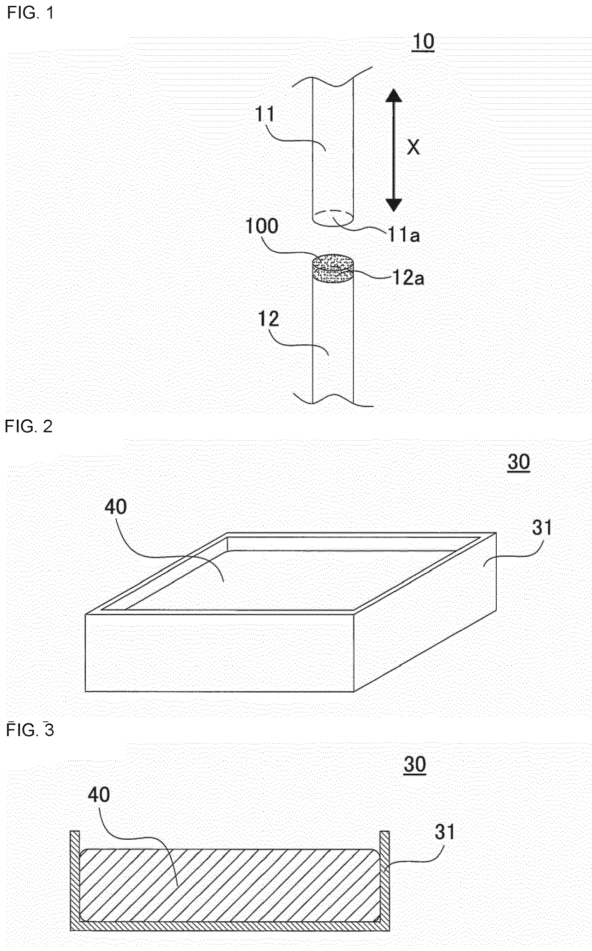

An adhesive strength of the soft thermal conductive member at a temperature of 25°C in which a circular area with a diameter of 13mm is defined as a unit area is 10N or less, but is preferably 0.1 to 9N, and particularly preferably 2 to 9N. The adhesive strength can be measured by an adhesive strength measuring system using a material testing instrument as shown in FIG. 1. FIG. 1 is a schematic diagram showing an adhesive strength measuring system for measuring the adhesive strength.

As shown in FIG. 1, the adhesive strength of the soft thermal conductive member can be measured by using a material testing instrument (not shown) having a measuring element 11 and a sample pedestal 12. For example, a compact-sized table-top testing instrument "EZ-SX (trade name)" manufactured by Shimadzu Corporation can be used as the material testing instrument. The measuring element 11 is a cylindrical round bar member having a driving direction in the X direction (vertical direction) of the paper surface. The sample pedestal 12 is a pedestal for disposing a soft thermal conductive member as the measurement sample 100, and is a cylindrical round bar member whose axial direction is the X direction of the paper surface. The sample pedestal 12 is fixed in the adhesive strength measuring system. The measuring element 11 and the sample pedestal 12 are made of SUS304, and each end face 11a and 12a opposed to each other has a circular shape with a diameter of 13mm.

The soft thermal conductive member serving as a measurement sample 100 has a circular plate shape having a diameter of 13mm and a thickness of 1mm. The measurement sample 100 is placed on the end face 12a of the sample pedestal 12, and the adhesive strength is measured.

In the measurement of the adhesive strength, the measuring element 11 is pushed into the measurement sample 100 placed on the sample pedestal 12 to a predetermined compression load, the maximum load [N] when the measuring element 11 is pulled up is measured, and the maximum load [N] is set as the adhesive strength [N] of the soft thermal conductive member as the measurement sample 100. As a measurement condition for measuring the adhesive strength, a temperature is set to 25°C, a compression speed at the time of pushing the measuring element 11 is set to 1mm/min, a compression load is set to 5N, and a tensile speed at the time of pulling up the measuring element 11 is set to 1000mm/min. In the soft thermal conductive member of the present embodiment, the adhesive strength measured as described above is 10N or less.

A thermal conductivity of the soft thermal conductive member is 0.4W/m K or more, preferably 2 to 4W/m·K, and particularly preferably 2 to 3.5W/m·K. The thermal conductivity of the soft thermal conductive member can be measured using a thermal conductivity measuring device. Examples of the thermal conductivity measuring device include "TCi-3-A (trade name)" manufactured by C-Therm Technologies Ltd.

The soft thermal conductive member is preferably clay-like. The term "clay-like" as used herein refers to a state in which a lump can be formed and the shape can be kept, and does not include a state in which it is difficult to keep the shape such as a liquid state or a grease state, a state in which a lump cannot be formed such as a powder state, and a state in which the shape is fixed to a constant state such as a solid state.

The soft thermal conductive member may further include a colorant, a base oil diffusion inhibitor, a thickener, and the like.

A method of manufacturing the soft thermal conductive member is not particularly limited, but examples thereof include the following methods.

First, a grease is prepared, and two kinds of thermal conductive particles having different average particle diameters are added to the prepared grease. As for the grease and the thermal conductive particles, those made of various materials described above as preferred examples can be used as appropriate. It is preferable to appropriately adjust the blending amount of the two kinds of thermal conductive particles so that the blending ratio of the first thermal conductive particles having an average particle diameter of 30 to 55µm and the second thermal conductive particles having an average particle diameter of 3 to 15µm in the soft thermal conductive member is 7:3 to 5:5 on a mass basis.

Next, the grease to which the thermal conductive particles are added is mixed so that the grease and the thermal conductive particles are uniformly mixed, whereby the soft thermal conductive member of the present embodiment can be manufactured. The mixing method is not particularly limited, and examples thereof include mixing and stirring using a rotation revolution stirrer.

Next, a low-reaction-force thermal conductive member which is another embodiment of the soft thermal conductive member will be described. The low-reaction-force thermal conductive member of the present embodiment is a low-reaction-force thermal conductive member 30 as shown in FIGS. 2 and 3. FIG. 2 is a perspective view schematically showing a low-reaction-force thermal conductive member which is another embodiment of the soft thermal conductive member. FIG. 3 is a cross-sectional view of the low-reaction-force thermal conductive member shown in FIG. 2.

As shown in FIGS. 2 and 3, the low-reaction-force thermal conductive member 30 includes a soft thermal conductive member 40 and a thermal conductive elastic body 31. The soft thermal conductive member 40 is composed of the soft thermal conductive member including the grease and the thermal conductive particles described above. In the low-reaction-force thermal conductive member 30 of the present embodiment, the thermal conductive elastic body 31 may be formed by forming an elastic body having a high thermal conductivity into a shape that threedimensionally follows the shape of the heat dissipation target. In the low-reaction-force thermal conductive member 30 of the present embodiment, the thermal conductive elastic body 31 serves as an outer layer, and the soft thermal conductive member 40 serves as an inner layer.

The thermal conductive elastic body 31 may be composed of a thermal conductive member having low adhesion. The material constituting the thermal conductive elastic body 31 is not particularly limited, and examples thereof include a material prepared by adding a thermal conductive filler having high thermal conductivity to a silicone rubber or an elastomer and mixing. The thermal conductivity is preferably 0.4W/m·K or more, and more preferably 1.0W/m·K or more. Further, the hardness of the material is preferably equal to or less than the hardness JIS-A90, and more preferably equal to or less than the hardness JIS-A60.

Examples of the thermal conductive fillers having insulation contained in the materials constituting the thermal conductive elasticity body 31 include metal oxides, metal nitrides, metal carbides, and metal hydroxides, and specific examples thereof include aluminum oxides (alumina), magnesium oxides (magnesia), zinc oxides, boron nitrides, aluminum nitrides, silicon carbides, aluminum dioxide, and aluminum hydroxides. In addition, examples of the thermal conductive fillers having electroconductivity include metal and carbon, and specific examples thereof include aluminum, copper, silver, carbon fiber, diamond, and graphite. However, the thermal conductive filler is not limited thereto. One kind may be used alone, or two or more kinds may be used in combination. When the thermal conductive elastic body 31 includes a thermal conductive filler having electroconductivity, the thermal conductive elastic body 31 may exhibit electroconductivity derived from the thermal conductive filler. When using such a thermal conductive elastic body 31 in a place where insulation is required, for example, by applying an insulation treatment by coating the thermal conductive member, or by providing an insulating member to the thermal conductive member, it is possible to ensure insulation with the thermal conductive elastic body 31.

The thermal conductive elastic body 31 is preferably formed in such a shape as to cover the heat dissipation target, in a shape in which the periphery of the heat dissipation target and the heat sink reliably come into contact with each other, and in a shape in which an arbitrary gap is provided between the heat dissipation target and the thermal conductive elastic body 31. Then, the soft thermal conductive member 40 is arranged in the gap of the thermal conductive elastic body 31. When the low-reaction-force thermal conductive member 30 is used, the soft thermal conductive member 40 in the gap is placed so as to cover the heat dissipation target, whereby the soft thermal conductive member 40 is compressed by the heat dissipation target and deformed, and the inside of the gap is filled with the soft thermal conductive member 40. Here, the shape of the thermal conductive elastic body 31 is not particularly limited, and examples thereof include a box-shaped body formed of a hollow rectangular parallelepiped having one surface (for example, a top surface) opened. The hollow portion of the box-shaped body serves as a gap for arranging the soft thermal conductive member 40. The outer dimensions of the thermal conductive elastic body 31 of the box-shaped body and the dimensions of the hollow portion serving as a gap are not particularly limited, and can be appropriately set according to the size of the heat dissipation target or the like.

The thermal conductive elastic body 31 can be manufactured by, for example, the following method. An alumina filler is added to the silicone rubber material and kneaded to obtain a thermal conductive rubber material. At this time, the thermal conductivity of the thermal conductive rubber material is preferably 0.4W/m·K or more, and more preferably 1.0W/m·K or more. The filler to be added to the rubber material is not limited to the alumina filler. The filler to be added to the rubber material is preferably one having a high thermal conductivity, and the thermal conductive fillers described above can be suitably used. The type of the rubber material is also not limited, but for example, when a large amount of alumina filler is blended, the above-described silicone rubber is preferable. Further, in order to encapsulate the soft thermal conductive member 40, it is preferable to have rubber elasticity, and it is preferable to obtain a thermal conductive rubber material by blending so as to have a tensile strength of 2.0MPa or more, an elongation of 200% or more, and a compression set of 20% or less.

Then, the thermal conductive elastic body 31 having a desired shape is produced by compression molding with a mold using the thermal conductive rubber material obtained as described above. The molding method is not limited to the compression molding described above. The shape of the thermal conductive elastic body 31 may be any shape as long as it is provided with a gap in which the heat dissipation target and the soft thermal conductive member 40 are filled, and examples thereof include a box-shaped body formed of a hollow rectangular parallelepiped having one surface opened as described above. Specifically, for example, the thermal conductive elastic member 31 may have an outer dimension of 25mm×25mm, a height of 5mm, and a gap dimension of 20mm×20mm and a depth of 4mm with respect to the heat dissipation target of 15mm×15mm and height of 3mm.

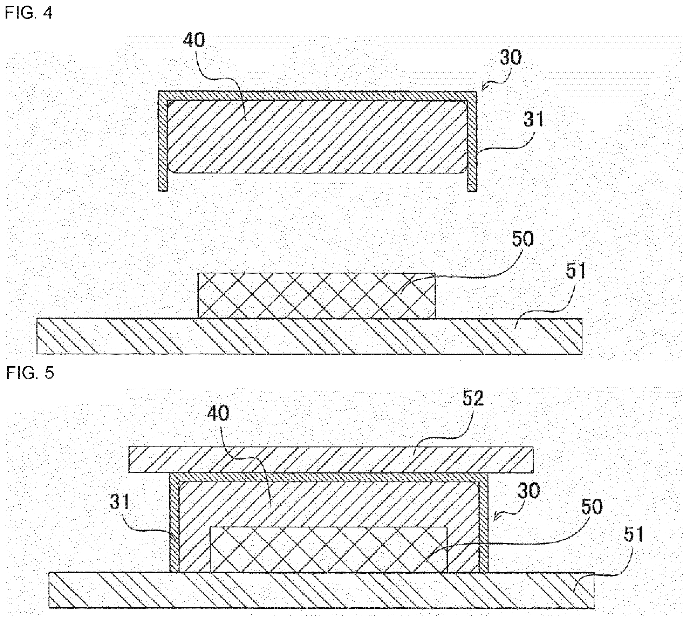

By setting the arrangement amount of the soft thermal conductive member 40 (in other words, the filling amount in the gap) to fill 70% or more of the volume of the gap after compression deformation, it is possible to efficiently transfer heat. When the low-reaction-force thermal conductive member 30 is used, for example, it can be used in the following manner. First, the soft thermal conductive member 40 is filled in the gap of the thermal conductive elastic body 31. The filling amount is preferably set so as not to exceed the amount obtained by subtracting the volume of the heating element which is the heat dissipation target from the gap. Then, as shown in FIG. 4, the thermal conductive elastic body 31 filled with the soft thermal conductive member 40 in the gap is arranged over the heat dissipation target 50 placed on the base material 51, and as shown in FIG. 5, the thermal conductive elastic body 31 is sandwiched by the heat sink 52, whereby low reaction force and efficient thermal conductivity can be exhibited. Here, FIGS. 4 and 5 are cross-sectional views showing a method of using the low-reaction-force thermal conductive member shown in FIG. 2. For example, the base material 51 may be a circuit substrate or the like, and the heat dissipation target 50 may be a heating element such as an IC chip placed on the circuit substrate.

In the low-reaction-force thermal conductive member 30 configured as described above, the soft thermal conductive member 40 and the thermal conductive elastic body 31 are continuously configured, and the periphery of the heat dissipation target is filled with the thermal conductive member, so that high thermal conductivity (heat dissipation) can be expected. In addition, since the soft thermal conductive member 40 has a low hardness, it has a low reaction force, and the load on the heat dissipation target is small. In addition, in a state in which the soft thermal conductive member 40 is included in the thermal conductive elastic body 31, it is possible to suppress deformation when the soft thermal conductive member 40 is arranged and outflow due to pump-out, and to maintain heat dissipation (thermal conductivity).

Further, since the soft thermal conductive member 40 and the thermal conductive elastic body 31 have low adhesion, the low-reaction-force thermal conductive member 30 has good handling property and can rework (reuse) parts. In addition, since the soft thermal conductive member 40 has small oil bleeding and the thermal conductive elastic body 31 has almost no oil bleeding, it is possible to reduce the influence of the oil on the heat dissipation target and to improve the long-term durability.

### Examples

Hereinafter, the present invention will be described in more detail based on Examples, but the present invention is not limited to these Examples.

The raw materials used in Examples and Comparative Examples are as follows.

### <Grease>

Grease A: Silicone grease "H.V.G (trade name)" manufactured by Toray Dow Corning Co., Ltd., consistency of 210

### <Thermal conductive particles>

Particle A: Alumina particles "DAM-45 (trade name)" manufactured by Denka Co., Ltd., average particle diameter of 45µm
Particle B: Alumina particles "DAM-05 (trade name)" manufactured by Denka Co., Ltd., average particle diameter of 5µm

**[Table 1]**

| | | Example 1 | Example 2 | Example 3 | Example 4 | Example 5 | Comparative Example 1 | Comparative Example 2 |
|---|---|---|---|---|---|---|---|---|
| Grease | Type | Grease A | Grease A | Grease A | Grease A | Grease A | Grease A | Grease A |
| | Trade name | H.V.G | H.V.G. | H.V.G. | H.V.G. | H.V.G. | H.V.G. | H.V.G. |
| | Consistency | 210 | 210 | 210 | 210 | 210 | 210 | 210 |
| | Blending ratio [parts bv mass] | 100 | 100 | 100 | 100 | 100 | 100 | 100 |
| First thermal conductive particles | Type | Particle A | Particle A | Particle A | Particle A | Particle A | Particle A | Particle A |
| | Trade name | DAM-45 | DAM-45 | DAM-45 | DAM-45 | DAM-45 | DAM-45 | DAM-45 |
| | Average particle diameter [µm] | 45 | 45 | 45 | 45 | 45 | 45 | 45 |
| | Blending ratio [parts bv mass] | 385 | 275 | 325 | 560 | 400 | 630 | 150 |
| Second thermal conductive particles | Type | Particle B | Particle B | Particle B | Particle B | Particle B | Particle B | Particle B |
| | Trade name | DAM-05 | DAM-05 | DAM-05 | DAM-05 | DAM-05 | DAM-05 | DAM-05 |
| | Average particle diameter [µm] | 5 | 5 | 5 | 5 | 5 | 5 | 5 |
| | Blending ratio [parts by mass] | 165 | 275 | 325 | 240 | 400 | 270 | 150 |
| Thermal conductive particles (total) | Blending ratio [parts by mass] | 550 | 550 | 650 | 800 | 800 | 900 | 300 |
| Shape retention | | OK | OK | OK | OK | OK | NG | NG |
| Thermal conductivity [W/m·K] | | 2.2 | 2.2 | 2.8 | 3.3 | 3.3 | Not measurable | 1.0 |
| Type OO hardness | | 11 | 11 | 15 | 41 | 50 | Not measurable | 0 |
| Adhesive strength [N] | | 7.0 | 8.4 | 4.7 | 4.3 | 2.6 | Not measurable | 11.3 |

### (Example 1)

A soft thermal conductive member was manufactured using grease A and two kinds of particles A and particles B as the thermal conductive particles. Specifically, with respect to 100 parts by mass of the grease A, 385 parts by mass of the particles A as the first thermal conductive particles and 165 parts by mass of the particles B as the second thermal conductive particles were added, and mixed using a rotation revolution stirrer, to manufacture a soft thermal conductive member of Example 1. Table 1 shows the blending formulation of the soft thermal conductive member of Example 1. Hereinafter, in the present embodiment, the soft thermal conductive member may be simply referred to as a thermal conductive member.

### (Example 2)

A thermal conductive member was manufactured using grease A and two kinds of particles A and particles B as the thermal conductive particles in the same manner as in Example 1 except that the blending formulation as shown in Table 1.

### (Example 3)

A thermal conductive member was manufactured using grease A and two kinds of particles A and particles B as the thermal conductive particles in the same manner as in Example 1 except that the blending formulation as shown in Table 1.

### (Example 4)

A thermal conductive member was manufactured using grease A and two kinds of particles A and particles B as the thermal conductive particles in the same manner as in Example 1 except that the blending formulation as shown in Table 1.

### (Example 5)

A thermal conductive member was manufactured using grease A and two kinds of particles A and particles B as the thermal conductive particles in the same manner as in Example 1 except that the blending formulation as shown in Table 1.

### (Comparative Examples 1 and 2)

A thermal conductive member was manufactured using grease A and two kinds of particles A and particles B as the thermal conductive particles in the same manner as in Example 1 except that the blending formulation as shown in Table 1.

Thermal conductive members of Examples 1 to 5 and Comparative Examples 1 and 2 were measured for thermal conductivity [W/m K], the type OO hardness, and adhesive strength [N] by the following methods. The results are shown in Table 1.

### <Thermal conductivity [W/m K]>

A thermal conductivity measuring device "TCi-3-A (trade name)" manufactured by C-Therm Technologies Ltd., was used to measure the thermal conductivity [W/m·K] of the thermal conductive member at a temperature of 25°C.

### <Type OO hardness>

The type OO hardness of the thermal conductive member was measured using a durometer "GSD-754K (trade name)" manufactured by Teclock Co., Ltd.

### <Adhesive strength [N]>

The adhesive strength [N] of the thermal conductive member was measured using a material testing instrument as shown in FIG. 1. As the material testing instrument, a compact-sized table-top testing instrument "EZ-SX (trade name)" manufactured by Shimadzu Corporation was used. Measuring element 11 and the sample pedestal 12 of the material testing instrument as shown in FIG. 1 are made of SUS304, each end face 11a and 12a opposed to each other has a circular shape with a diameter of 13mm, and the thermal conductive member as the measurement sample 100 has a circular plate shape having a diameter of 13mm and a thickness of 1mm. In the measurement of the adhesive strength, the measuring element 11 is pushed into the measurement sample 100 placed on the sample pedestal 12 to a predetermined compressive load, the maximum load [N] when the measuring element 11 is pulled up is measured, and the maximum load [N] is set as the adhesive strength [N] of the thermal conductive member. As a measurement condition for measuring the adhesive strength, a temperature is set to 25°C, a compression speed at the time of pushing the measuring element 11 is set to 1mm/min, a compression load is set to 5N, and a tensile speed at the time of pulling up the measuring element 11 is set to 1000mm/min. Note that the measured adhesive strength [N] can be said to be an adhesive strength [N/ϕ3mm] in which a circle with a diameter of 13mm is defined as a unit area.

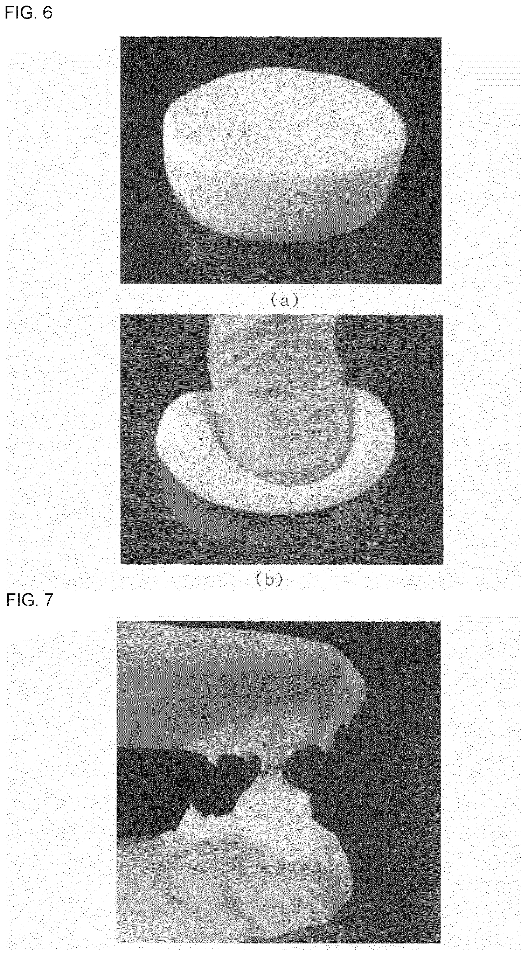

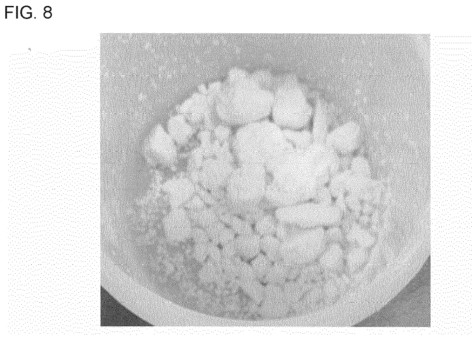

In addition, evaluation of the shape retention of the thermal conductive members of Examples 1 to 5 and Comparative Examples 1 and 2 was performed based on the following evaluation criteria. A case where the shape of the thermal conductive member is clay-like and not crumbly, and a lump can be formed and the shape can be kept is regarded as passing, and is indicated as "OK" in Table 1. A case where the shape of the thermal conductive member is a liquid state or a grease state, the thermal conductive member has adhesion, and cannot form a shape, or the shape of the thermal conductive member is a powder state in which the thermal conductive member is crumbly and does not form a lump is regarded as fail, and is indicated as "NG" in Table 1. FIG. 6 shows an example of a case where the shape of the thermal conductive member is clay-like. FIG. 7 shows an example of a case where the shape of the thermal conductive member is a liquid state or a grease state. FIG. 8 shows an example of a case where the shape of the thermal conductive member is a powder state. FIGS. 6 to 8 are photographs showing the shape of a thermal conductive member.

### (Result 1)

As shown in Tables 1, the thermal conductive members of Examples 1 to 5 had a thermal conductivity of 0.4W/mK or more, an adhesive strength of 10N or less, and the type OO hardness of 70 or less. In the evaluation of the shape retention, good results were obtained in all of them. That is, the thermal conductive members of Examples 1 to 5 were clay-like in shape, were not crumbly, and can form a lump and keep the shape. On the other hand, in the thermal conductive member of Comparative Example 1, the blending ratio of the thermal conductive particles was too large to measure the thermal conductivity, the adhesive strength, and the type OO hardness. In the thermal conductive member of Comparative Example 1, the blending ratio of the thermal conductive particles was too low to keep the shape, and the type OO hardness was 0.

### (Comparative Example 3)

As the thermal conductive member of Comparative Example 3, a silicone putty sheet "PG25A (trade name)" manufactured by Fuji Polymer Industries Co., Ltd. was prepared. The thermal conductive member of Comparative Example 3 had a putty form.

### (Comparative Example 4)

As the thermal conductive member of Comparative Example 4, a silicone gel sheet "GR45A (trade name)" manufactured by Fuji Polymer Industries Co., Ltd. was prepared. The thermal conductive member of Comparative Example 4 had a gel form.

### (Comparative Example 5)

As the thermal conductive member of Comparative Example 5, a silicone gel sheet "TC-100CAS-30 (trade name)" manufactured by Shin-Etsu Chemical Co., Ltd. was prepared. The thermal conductive member of Comparative Example 5 had a gel form.

### (Comparative Example 6)

As the thermal conductive member of Comparative Example 6, a silicone gel sheet "COH-4000LVC (trade name)" manufactured by Taica Corporation was prepared. The thermal conductive member of Comparative Example 6 had a gel form.

### (Comparative Example 7)

As the thermal conductive member of Comparative Example 7, a silicone compound "SPG30B (trade name)" manufactured by Fuji Polymer Industries Co., Ltd. was prepared. The thermal conductive member of Comparative Example 7 had a gel form.

The adhesive strength [N] of the thermal conductive members of Comparative Examples 4 to 7 was measured by the above-described method. The results are shown in Table 2. The silicone gel sheet of Comparative Example 6 had a tickness of 0.5mm, and therefore, the measuremnet of the adhesive strength was performed with two silicone gel sheets stacked.

**[Table 2]**

| | Example 1 | Example 2 | Example 3 | Example 4 | Example 5 | Comparative Example 3 | Comparative Example 4 | Comparative Example 5 | Comparative Example 6 | Comparative Example 7 |
|---|---|---|---|---|---|---|---|---|---|---|
| Form | Clay | | | | | Putty | Gel sheet | | | Compound |
| Thermal conductivity [W/m·K] | 2.2 | 2.2 | 2.8 | 3.3 | 3.3 | 2.8 | 6.0 | 2.7 | 2.1 | 3.1 |
| Adhesive strength [N] | 7.0 | 8.4 | 4.7 | 4.3 | 2.6 | 13.2 | 11.1 | 11.5 | 17.3 | 15.6 |
| Remarks | | | | | | | | | 2 sheets stacked (0.5mm x 2 sheets) | |

### (Result 2)

As shown in Table 2, the thermal conductive members of Examples 1 to 5 had an adhesive strength of 10N or less and a low adhesion for improving handling property, whereas the thermal conductive members of Comparative Examples 3 to 7 had an adhesive strength exceeding 10N and a poor handling property.

### Industrial applicability

The soft thermal conductive member of the present invention can be used as a heat dissipation component of an automobile or an electronic device.

### Description of Reference numerals

10: adhesive strength measuring system
11: measuring element
11a: end face (end face of the measuring element)
12: sample pedestal
12a: end face (end face of sample pedestal)
30: low-reaction-force thermal conduction member
31: thermal conductive elastic body
40: soft thermal conductive member
50: heat dissipation target
51: base material
52: heat sink
100: measurement sample

## Claims

1. A soft thermal conductive member comprising grease and thermal conductive particles, wherein
the thermal conductive particles are contained in an amount of 550 to 800 parts by mass with respect to 100 parts by mass of the grease,
the thermal conductive particles are composed of first thermal conductive particles having an average particle diameter of 30 to 55µm and second thermal conductive particles having an average particle diameter of 3 to 15µm, and a blending ratio of the first thermal conductive particles and the second thermal conductive particles is 7:3 to 5:5 on a mass basis,
the type OO hardness is 70 or less,
an adhesive strength at a temperature of 25°C in which a circular area with a diameter of 13mm is defined as a unit area is 10N or less, and
a thermal conductivity is 0.4W/m·K or more.

2. The soft thermal conductive member according to claim 1, wherein the average particle diameter of the first thermal conductive particles is 35 to 50µm, and the average particle diameter of the second thermal conductive particles is 4.5 to 9µm.

3. The soft thermal conductive member according to claim 1 or 2, wherein the grease comprises a silicone grease.

4. The soft thermal conductive member according to any one of claims 1 to 3, wherein the thermal conductive particles are particles made of at least one material selected from the group consisting of metal oxides, metal nitrides, metal carbides, and metal hydroxides.

5. The soft thermal conductive member according to claim 4, wherein the thermal conductive particles are any one of aluminum oxide particles, magnesium oxide particles, zinc oxide particles, boron nitride particles, aluminum nitride particles, silicon carbide particles, and aluminum hydroxide particles.

6. The soft thermal conductive member according to any one of claims 1 to 5, wherein the consistency of the grease is 150 to 300.

7. The soft thermal conductive member according to any one of claims 1 to 6, which is clay-like.

8. The soft thermal conductive member according to any one of claims 1 to 7, wherein the type OO hardness is 0.5 to 60.

9. The soft thermal conductive member according to any one of claims 1 to 8, wherein the thermal conductivity is 2 to 4W/m K.

10. The soft thermal conductive member according to any one of claims 1 to 9, wherein an adhesive strength at a temperature of 25°C of a circular area with a diameter of 13mm which is a unit area is 0.1 to 10N.
